# EUROPÄISCHE PATENTANMELDUNG

(11) **EP 4 685 508 A1**
(43) Veröffentlichungstag der Anmeldung: **28.01.2026**
(21) Anmeldenummer: 24191212.0
(22) Anmeldetag: 26.07.2024
(51) Int. Cl.: G01R 33/385

(54) **ENDSTUFENSYSTEM FÜR EINEN GRADIENTENVERSTÄRKER**

(71) Anmelder: Siemens Healthineers AG, 91301 Forchheim (DE)
(72) Erfinder: Schork, Franz, 90559 Burgthann (DE)
(74) Vertreter: Siemens Healthineers Patent Attorneys

(57) **Zusammenfassung**

Die Erfindung betrifft ein Endstufensystem (20) für einen Gradientenverstärker umfassend mehrere Endstufen (21) für unterschiedliche Gradientenspulen (X, Y, Z), wobei jede der Endstufen (21) mehrere Zylinder aufweist und, wobei jeder Zylinder (22) zumindest eine Schaltung aus einer Kondensatoreinheit (24) und mindestens einer Brückeneinheit (25) umfasst, wobei mehrere Brückeneinheiten (25) seriell als Endstufenausgang (E) verschaltet sind, und wobei Brückeneinheiten (25) von zumindest zwei unterschiedlichen Endstufen (21) mit derselben Kondensatoreinheit (24) verbunden sind. Des Weiteren umfasst die Erfindung ein Verfahren, ein Gradientensystem und ein Magnetresonanztomographiesystem.

## Beschreibung

Die Erfindung betrifft ein Endstufensystem für einen Gradientenverstärker, ein Verfahren zur Steuerung eines Endstufensystems, ein Gradientensystem für ein Magnetresonanztomographiesystem und ein Magnetresonanztomographiesystem.

Im Bereich der Magnetresonanztomographie (MRT) werden neben dem starken Hauptmagnetfeld sogenannte Gradientenfelder benötigt. Zwar sind diese nicht so stark wie das Hauptmagnetfeld, es ist dennoch eine vergleichsweise hohe Leistung erforderlich. Zur Erzeugung der Gradientenfelder dienen Gradientenspulen. Diese sind typischerweise linear unabhängig voneinander zur X-Achse, Y-Achse und Z-Achse ausgerichtet und werden oftmals als X-, Y- und Z-Gradientenspulen bezeichnet.

Für die Erzeugung dreier voneinander unabhängiger Gradientenstromimpulse (für die X-, Y- und Z-Achse) mit einer Gradientenspule wird zum Erzeugen der dazu notwendigen Leistung ein sogenannter Gradientenverstärker (GPA) verwendet. Da die Gradientenpulse typischerweise mit einer vorgegebenen Flankensteilheit variieren muss der GPA diese Stromsteilheit und eine geeignete Stromamplitude emittieren können, um über die Gradientenspulen ein für die Bildgebung akzeptables Feld aufzubauen.

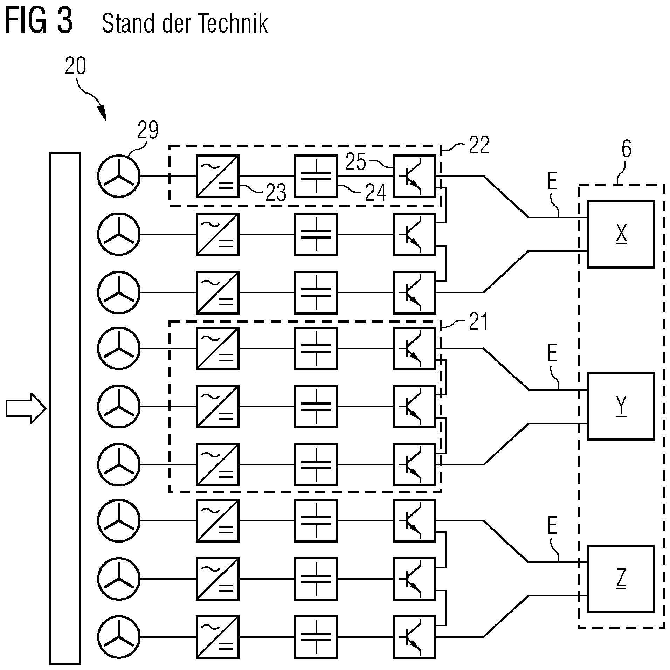

Bisher wurde für die Erzeugung der unabhängigen Stromimpulse im GPA das in der Figur 3 gezeigte Konzept verwendet. Für jede Achse (X, Y, Z) wird in einer sogenannten "Endstufe" die Leistung für die jeweilige Gradientenspule bereitgestellt. Jede Endstufe umfasst in der Regel drei bis fünf durch Trafos voneinander galvanisch getrennte Sekundärsysteme, sogenannte "Zylinder", die je nach Strompulsanforderung geschaltet werden können.

Jeder Zylinder umfasst typischerweise eine Schaltung aus einer Stromwandlungseinheit (in der Regel aus einem Gleichrichter), einer von der Stromwandlungseinheit ständig aufgeladenen Kondensatoreinheit und einer mit der Kondensatoreinheit elektrisch verbundenen Brückeneinheit, die in der Regel eine H-Brücke oder ein H-Brücken-System ist. Durch die Verschaltung der Zylinder, genauer der Brückeneinheiten einer Endstufe, kann ein Mehrfaches der von einer Stromwandlungseinheit zur Verfügung stehenden Spannung erzeugt werden.

Auch wenn getrennte Transformatoren für jeden Zylinder verwendet werden können, wird oftmals ein Transformator mit einer Sekundärwicklung pro Zylinder benutzt. Je Achse ergibt sich dabei eine Endstufe für X, eine für Y und eine für Z. Der Transformator besitzt in der Endausbaustufe für drei Zylinder GPAs, 9 Sekundärsysteme und für fünf Zylinder GPAs 15 Sekundärsysteme.

Eine galvanische Trennung muss nicht zwingend mit einem Transformator erfolgen. Es ist auch möglich, DC/DC-Konverter oder AC/DC-Konverter zu verwenden, welche dann die benötigte Spannung direkt erzeugen oder eine Vielzahl von Konvertern übereinander zu schalten. Nachteilig an dem Konzept der Konverter im Vergleich zum Transformator, ist die geringe Überlastfähigkeit die gerade bei hohen kurzzeitigen Stromimpulsen notwendig ist. Dies muss bei Konvertern durch sehr große Kapazitäten oder eine insgesamt größere Leistungsklasse ausgeglichen werden, was dieses Konzept bei hohem Kostendruck und gleichzeitig niedrigem Bauvolumen schnell an die Grenzen des Machbaren bringt.

Es ist eine Aufgabe der vorliegenden Erfindung, ein Endstufensystem für einen Gradientenverstärker, ein Verfahren zur Steuerung eines Endstufensystems, ein Gradientensystem für ein Magnetresonanztomographiesystem und ein Magnetresonanztomographiesystem anzugeben, mit denen die oben beschriebenen Nachteile vermieden werden.

Diese Aufgabe wird durch ein Endstufensystem gemäß Patentanspruch 1, ein Verfahren gemäß Patentanspruch 10, ein Gradientensystem gemäß Patentanspruch 12 und ein Magnetresonanztomographiesystem gemäß Patentanspruch 13 gelöst.

Ein erfindungsgemäßes Endstufensystem für einen Gradientenverstärker umfasst mehrere Endstufen für unterschiedliche Gradientenspulen, wobei jede der Endstufen mehrere Zylinder aufweist und, wobei jeder Zylinder zumindest eine Schaltung aus einer Kondensatoreinheit und mindestens einer Brückeneinheit umfasst, wobei mehrere Brückeneinheiten seriell als Endstufenausgang verschaltet sind, und wobei Brückeneinheiten von zumindest zwei unterschiedlichen Endstufen mit derselben Kondensatoreinheit verbunden sind.

Die Kondensatoreinheiten der Zylinder werden in der Regel von Trafos (meist eine Sekundärwicklung pro Zylinder an einem gemeinsam genutzten Magnetjoch eines Trafos) mit Energie versorgt, also aufgeladen. In diesem Falle wird der Wechselstrom typischerweise mit einer Stromwandlungseinheit in Gleichstrom konvertiert. Die Stromwandlungseinheit ist typischerweise ein Gleichrichter, kann aber auch durch andere Bauelemente realisiert werden (z.B. Steller). Schaltungen zum Aufladen der Kondensatoreinheit sind im Stand der Technik bestens bekannt und werden hier nicht mehr näher erläutert. Bei jedem Zylinder wird also die mit ihr verbundene Kondensatoreinheit stetig aufgeladen und die Brückeneinheiten greifen die Ladungen der einzelnen Kondensatoreinheiten zur Formung des Gradientensignals ab. Dabei sind die vier Eingänge der H-Brücke(n) der Brückeneinheiten paarweise mit der Kondensatoreinheit verbunden und die beiden Ausgänge jeweils in Reihe geschaltet, dass bei drei Brückeneinheiten der erste Ausgang der ersten Brückeneinheit den Endstufenausgang "-" bildet, der zweite Ausgang der ersten Brückeneinheit mit dem ersten Ausgang der zweiten Brückeneinheit verbunden ist, der zweite Ausgang der zweiten Brückeneinheit mit dem ersten Ausgang der dritten Brückeneinheit verbunden ist, und der zweite Ausgang der dritten Brückeneinheit den Endstufenausgang "+" bildet. Es sollte hier beachtet werden, dass "+" und "-" nicht zwingend die technische Stromrichtung anzeigen, sondern nur zur Unterscheidung der beiden Anschlüsse für eine Gradientenspule dienen sollen. An die beiden Endstufenausgänge kann dann eine Gradientenspule angeschlossen werden. Diese Verschaltung ist im Stand der Technik gut bekannt.

Der Unterschied der Erfindung zum Stand der Technik liegt nun darin, dass eine Schaltung aus der Kondensatoreinheit (und damit bevorzugt auch aus einer Stromwandlungseinheit) für mehrere Brückeneinheiten unterschiedlicher Endstufen verwendet wird. Man kann sich dies so vorstellen, dass man zunächst einen herkömmlichen GPA aus drei Endstufen mit jeweils drei Zylindern pro Endstufe betrachtet. In jeder Endstufe gibt es eine erste, zweite und dritte Brückeneinheit. Wenn man nun jeweils die zweiten Brückeneinheiten jeder Endstufe an dieselbe Kondensatoreinheit anschließt, hat man die Zylinder zu einer Ausführungsform für ein erfindungsgemä-βes Endstufensystem verschaltet. Dies würde zwei Zylinderteile einsparen, nämlich insgesamt zwei Kondensatoreinheiten (also zwei Leistungskondensatoren) und ggf. auch zwei Stromwandlungseinheiten (insbesondere Gleichrichtern).

Im Grunde spart das erfindungsgemäße Endstufensystem Zylinder ein, da der Hauptteil des Zylinders, der Volumen, Gewicht und Kosten ausmacht, nämlich die (optionale) Stromwandlungseinheit und die Kondensatoreinheit für mehrere Brückeneinheiten verwendet werden. Wichtig ist hierbei, dass Brückeneinheiten von zumindest zwei unterschiedlichen Endstufen (also für unterschiedliche Gradientenspulen) mit derselben Kondensatoreinheit (und damit ggf. auch derselben Stromwandlungseinheit) verbunden sind.

In der Praxis hat ein Zylinder oftmals eine Trafowindung, einen Gleichrichter, eine Zwischenkreiskapazität und eine H-Brücke. Diese werden dann zusammen mit anderen Zylindern in eine Endstufe eingebaut, die man sich wie eine Metallbox mit den Komponenten vorstellen kann. Die einzelnen Zylinder werden dann direkt (wenn Gleichrichter in der Endstufe integriert sind) von den Sekundärwicklungen des Trafos versorgt. Da bei leistungsstarken GPAs die Gleichrichter aus Platzgründen häufig nicht mehr in die Endstufenbox passen, werden die Gleichrichter dann ausgelagert.

Durch die gemeinsame Nutzung einer Kondensatoreinheit (oder mehrerer), kann nun der Fall auftreten, dass Gradientenspulen durch spezielle Schalterstellungen der Brückeneinheiten miteinander verschaltet werden. Auch könnte ein Kurzschluss einer Kondensatoreinheit geschaltet werden oder zwei Kondensatoreinheiten miteinander kurzgeschlossen werden. Dies ist nicht erwünscht. Auch im Stand der Technik kann dies passieren, z.B. wenn alle Schalter einer Brückeneinheit geschaltet werden. Daher sollte darauf geachtet werden, dass spezielle Schalterstellungen ("verbotene Schaltkombinationen"), die bekannt sind, nicht vorkommen. Dies kann recht einfach durch eine Verschaltung mit logischen Gattern oder einer entsprechend gestalteten Softwareumsetzung erfolgen.

Des Weiteren sollte beachtet werden, dass zunächst nicht vorgegeben wird, welcher Schalter welche Brückeneinheit wann geschaltet werden soll. Zu Beginn wird vielmehr ein Soll-Stromverlauf vorgegeben, mit dem die gewünschten Gradientenfelder erzeugt werden sollen. Eine Steuerlogik leitet daraus Schaltmuster für die Brückeneinheiten ab. Fest verschaltet ist dabei, dass bestimmte Schaltzustände jeder H-Brücke der Brückeneinheiten (nämlich beide Schalter derselben Ausgänge geschaltet) verboten sind. Es kann durchaus sein, dass das gleiche Sollwertsignal andere Schalterkombinationen verlangt, weil andere Störgrößen (Temperatur, Rauschen, usw.) in den jeweiligen Zeitpunkten vorliegen. Die Regelung erkennt das durch einen Vergleich des Sollwerts mit dem Istwert und behebt diese Abweichung mit einer anderen Schalterkombination. Dieser Vorgang ist Stand der Technik.

Ein erfindungsgemäßes Verfahren dient zur Steuerung eines erfindungsgemäßen Endstufensystems. Es umfasst die folgenden Schritte:
- Vorgeben einer Liste oder Tabelle von verbotenen Schaltkombinationen für die Brückeneinheiten des Endstufensystems,
- Empfangen eines Datenstroms mit einem Soll-Stromverlauf für eine Untersuchung
- Ermittlung von Soll-Schaltkombinationen, mit denen die Brückeneinheiten geschaltet werden müssen, um den Soll-Stromverlauf zu erreichen,
- Ausgabe von Steuerbefehlen zum Schalten der Schalter der Brückeneinheiten gemäß der Soll-Schaltkombinationen, wobei verbotene Schaltkombinationen unterdrückt werden.

Hat bei jeder Brückeneinheit der erste Schalter des ersten Ausgangs die Nummer "1", der zweite Schalter des ersten Ausgangs die Nummer "2", der erste Schalter des zweiten Ausgangs die Nummer "3" und der zweite Schalter des zweiten Ausgangs die Nummer "4", so wären die Schaltkombinationen 1+2 und 2+3 jeder H-Brücke verboten (Stand der Technik). Bei der Erfindung kommt neu hinzu, dass auch Schalterstellungen unterschiedlicher Endstufen (X, Y, Z) verboten sind, nämlich X1+Y2, X2+Y1, X2+Y3, X3+Y2, X3+Y4 und X4+Y3 sowie X1+Z2, X2+Z1, X2+Z3, X3+Z2, X3+Z4 und X4+Z3 sowie Y1+Z2, Y2+Z1, Y2+Z3, Y3+Z2, Y3+Z4 und Y4+Z3.

Ein erfindungsgemäßes Gradientensystem für ein Magnetresonanztomographiesystem umfasst eine Anzahl von Gradientenspulen und ein Endstufensystem gemäß der Erfindung, wobei jeweils eine Gradientenspule mit einem Endstufenausgang einer Endstufe des Endstufensystems verbunden ist.

Ein erfindungsgemäßes Magnetresonanztomographiesystem umfasst ein Gradientensystem gemäß der Erfindung.

Weitere, besonders vorteilhafte Ausgestaltungen und Weiterbildungen der Erfindung ergeben sich aus den abhängigen Ansprüchen sowie der nachfolgenden Beschreibung, wobei die Ansprüche einer Anspruchskategorie auch analog zu den Ansprüchen und Beschreibungsteilen zu einer anderen Anspruchskategorie weitergebildet sein können und insbesondere auch einzelne Merkmale verschiedener Ausführungsbeispiele bzw. Varianten zu neuen Ausführungsbeispielen bzw. Varianten kombiniert werden können.

Ein bevorzugtes Endstufensystem zeichnet sich dadurch aus, dass der Gradientenverstärker mindestens drei Endstufen umfasst und mindestens eine Brückeneinheit von jeder der Endstufen mit derselben Kondensatoreinheit verbunden ist. Es existiert also eine Endstufe für eine X-Gradientenspule, eine Endstufe für eine Y-Gradientenspule und eine Endstufe für eine Z-Gradientenspule. Jeweils eine Brückeneinheit jeder Endstufe teilt sich eine Kondensatoreinheit mit Brückeneinheiten der jeweils anderen Endstufen. Die kann für jeweils eine Brückeneinheit jeder Endstufe gelten oder für mehrere Brückeneinheiten. Das Endstufensystem kann als Teil des Gradientenverstärkers ausgebildet sein oder den Gradientenverstärker umfassen.

Es ist dabei bevorzugt, dass jeweils eine erste Brückeneinheit von jeder der Endstufen mit derselben ersten Kondensatoreinheit verbunden ist, und zusätzlich jeweils eine zweite (von der ersten Brückeneinheit verschiedene) Brückeneinheit von jeder der Endstufen mit derselben zweiten (von der ersten Kondensatoreinheit verschiedene) Kondensatoreinheit verbunden ist. Je mehr Brückeneinheiten sich eine Kondensatoreinheit teilen, desto mehr Elektronikkomponenten der Zylinder (Kondensatoreinheiten und ggf. Stromwandlungseinheiten) können eingespart werden.

Ein bevorzugtes Endstufensystem zeichnet sich dadurch aus, dass jeder Endstufenausgang dieselbe Anzahl von seriell verschalteten Brückeneinheiten umfasst, bevorzugt mindestens drei, fünf oder sieben. Es könnten auch geradzahlige Zylinderanordnungen vorliegen, jedoch sind ungeradzahlige bevorzugt.

Ein bevorzugtes Endstufensystem zeichnet sich dadurch aus, dass die Serienschaltung der Brückeneinheiten jedes Endstufenausgangs eine funktionale Reihenfolge hat, welche von den Magnetfeldern von bestimmungsgemäß an die Endstufen angeschlossenen Gradientenspulen bestimmt wird. In einer Reihenschaltung mit vorgegebener Stromrichtung wäre eine funktionale Reihenfolge z.B. die Reihung der Komponenten in Stromrichtung. Da bei Gradientenspulen der Strom in beide Richtungen fließen kann, könnte eine geeignete Reihenfolge auch vom Magnetfeld der Gradientenspulen in Richtung der Koordinatenachsen des MRT-Systems abhängen.

Es ist dabei bevorzugt, dass Brückeneinheiten von zumindest zwei unterschiedlichen Endstufen, die mit derselben Kondensatoreinheit verbunden sind, jeweils bezüglich ihrer Stellung in der Reihenfolge gleichartige Brückeneinheiten sind. Dies ist zwar nicht unbedingt notwendig, aber sehr vorteilhaft für die Formung von Magnetfeldern der Gradientenspulen.

Bei einem bevorzugten Endstufensystem ist zumindest eine Brückeneinheit jeder der Endstufen von den anderen Endstufen galvanisch getrennt. Eine solche galvanische Trennung vermindert die Anzahl der verbotenen Schalterstellungen. Die galvanische Trennung betrifft bevorzugt eine Brückeneinheit am Anfang oder am Ende der Serienschaltung der betreffenden Endstufe. Dies ist ebenfalls sehr vorteilhaft für die Verminderung verbotener Schaltzustände.

Ein bevorzugtes Endstufensystem umfasst ein Verriegelungssystem, welches vorgegebene Schaltkombinationen der Brückeneinheiten verhindert, insbesondere blockiert. Es ist dabei bevorzugt, dass das Verriegelungssystem dazu ausgestaltet ist, Schaltkombinationen zu unterdrücken oder nicht erst zu generieren, die
- zu einem Kurzschluss zwischen den Anschlüssen einer Kondensatoreinheit führen,
- zu einer direkten Verbindung zwischen den Anschlüssen zweier Kondensatoreinheiten führen, oder
- zu Lastschlüssen (Verbindung von zwei Gradientenspulen) führen.

Ein bevorzugtes Endstufensystem zeichnet sich dadurch aus, dass das Verriegelungssystem für jedes Schaltsignal eines Schalters einer Brückeneinheit (typischerweise 4 Schaltsignale pro Brückeneinheit für die 4 Schalter der H-Brücke) eine Riegeleinheit (Als Teil einer Verriegelungseinheit) umfassend eine Anordnung logischer Gatter umfasst (Hardwaregatter oder in Software umgesetzt). Diese Gatter sind insbesondere AND-Gatter und/oder NAND-Gatter, bevorzugt ein AND-Gatter mit einem zusätzlichen invertierenden Ausgang und mehreren Eingängen. Bevorzugt umfasst dabei jede Riegeleinheit einen Eingang für ein Schaltsignal und eine Anzahl von Eingängen für Riegelsignale sowie einen Ausgang für das Schaltsignal und bevorzugt einen Ausgang für das invertierte Schaltsignal. Es ist dabei bevorzugt, dass die Ausgänge der Riegeleinheiten des Verriegelungssystems mit den Eingängen anderer Riegeleinheiten des Verriegelungssystems verbunden sind und Riegelsignale an diese übertragen. Zusätzlich oder alternativ zu dem Verriegelungssystem ist bevorzugt, dass das Endstufensystem so ausgestaltet ist, dass verbotene Schalterzustände (von vorneherein) nicht generiert werden.

Es wird hier angemerkt, dass es sich hier, obwohl die Schalter mittels Signalen angesteuert werden, genaugenommen um eine Regelung handelt. Typischerweise (im Stand der Technik bekannt) existiert eine Regelstrecke, die den GPA umfasst, und diesen in seiner Dynamik einschränkt (durch Reduktion der möglichen Schaltzustände). Allgemein wird jedoch ein Sollwert vorgegeben und bei der Ausgabe des Stroms an die Spule noch einmal überprüft, ob der Sollwert erreicht worden ist. Aufgrund der Überprüfung wird dann ggf. durch andere Schalterstellungen der Ausgangsstrom nachgeregelt. Die Regelung versucht also die Strecke so zu führen, dass der Istwert dem Sollwert entspricht. Die vorliegende Erfindung greift jedoch an der Verschaltung der Brückeneinheiten und deren "verbotenen" Zuständen an, liegt also im Grunde mitten im den Schalt-Teil der Regelung. Um Missverständnissen vorzubeugen, werden hier die Begriffe "Schalteinheit" und "Schaltsignale" verwendet, welche als Teil der übergeordneten Regelung angesehen werden sollten.

Ein bevorzugtes Endstufensystem zeichnet sich dadurch aus, dass jede Brückeneinheit eine H-Brücke mit mindestens vier Schaltern aufweist. Das Endstufensystem umfasst dann bevorzugt eine Schalteinheit, die dazu ausgelegt ist, die Schalter der Brückeneinheiten nach einem jeweils vorgegebenen Schaltmuster zu schalten. Um die Leistung zu erhöhen, werden in einer H-Brücke oft bis zu 7 IGBTs (bipolare Feldeffekttransistoren) pro Schalter parallel geschaltet. In einer H-Brücke sind also in diesem Fall 28 IGBTs, von denen immer 7 blockweise als ein Schalter agieren. Es ist dabei bevorzugt, dass bei einem Endstufensystem gemäß der Erfindung das Verriegelungssystem dazu ausgelegt ist, vorgegebene Schaltkombinationen des Schaltmusters der Schalteinheit zu unterdrücken.

Ein bevorzugtes Endstufensystem umfasst eine Aktivierungs-Steuereinheit dazu ausgelegt, eine Brückeneinheit zu aktivieren oder deaktivieren, bevorzugt jede Brückeneinheit (blockweise für jede Endstufe). Es ist dabei bevorzugt, dass die Aktivierungs-Steuereinheit dazu ausgelegt ist, bei einer Endstufe gemäß Anspruch 7 eine Anzahl von Brückeneinheiten (bevorzugt alle Brückeneinheiten der Endstufe) mittels des Verriegelungssystems zu aktivieren oder deaktivieren, vorzugsweise indem sie dazu ausgelegt ist, alle mit einer Endstufe verbundenen Riegeleinheiten blockweise zu aktivieren oder zu deaktivieren.

Gemäß einer bevorzugten Ausführungsform des Verfahrens ist ein Aktivierungsmuster vorgegeben, nach dem die Schaltsignale für die Gradientenspulen blockweise aktiviert werden, bevorzugt so dass zu jedem Zeitpunkt Schaltsignale für zwei der Gradientenspulen aktiv sind und die Schaltsignale für eine weitere Anzahl von Gradientenspulen inaktiv sind, wobei die Schalter der Brückeneinheiten gemäß einem vorgegebenen Aktivierungsmuster und der gewünschten Schaltkombinationen geschaltet werden. Das Aktivierungsmuster gibt dabei vor, welche Schaltergruppen zu welchem Zeitpunkt aktiv sind und welche inaktiv sind.

Die Aktivierungs-Einheit kann durchaus Teil der oben angesprochenen übergeordneten Regelung sein. Die Aktivierung der einzelnen Zylinder kann diesbezüglich insbesondere je nach geforderter Stromsteilheit in den Achsen erfolgen. Dies hat den Vorteil gegenüber eines fest vorgegeben Einschaltens, dass möglich "Steilheitsreserven" unter den Achsen situativ verteilt werden können.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine schematische Darstellung eines Magnetresonanztomographiesystems mit einer Vorrichtung gemäß einem Ausführungsbeispiel der Erfindung,
Figur 2 eine Endstufe mit einer Gradientenspule,
Figur 3 drei Endstufen für drei Gradientenspulen gemäß dem Stand der Technik,
Figur 4 ein Beispiel für ein erfindungsgemäßes Endstufensystem mit drei Gradientenspulen,
Figur 5 die Verschaltung der H-Brücken der Brückeneinheiten eines erfindungsgemäßen Endstufensystems,
Figur 6 ein Beispiel für eine verbotene Schaltkombination der H-Brücken der Brückeneinheiten eines erfindungsgemäßen Endstufensystems,
Figur 7 eine Tabelle mit verbotenen Schaltkombinationen der X-Endstufe,
Figur 8 eine Tabelle mit verbotenen Schaltkombinationen zwischen X-Endstufe und Y-Endstufe,
Figur 9 eine Tabelle mit verbotenen Schaltkombinationen zwischen X-Endstufe und Z-Endstufe,
Figur 10 eine Schalteinheit für Brückeneinheiten,
Figur 11 eine Riegeleinheit einer Verriegelungseinheit zur Unterdrückung von Schaltsignalen,
Figur 12 ein Beispiel für ein Aktivierungsmuster,
Figur 13 ein erfindungsgemäßes Endstufensystem mit drei Gradientenspulen, Schalteinheit, Verriegelungssystem und Aktivierungs-Steuereinheit,
Figur 14 den Ablauf des Verfahrens als Blockschaltbild.

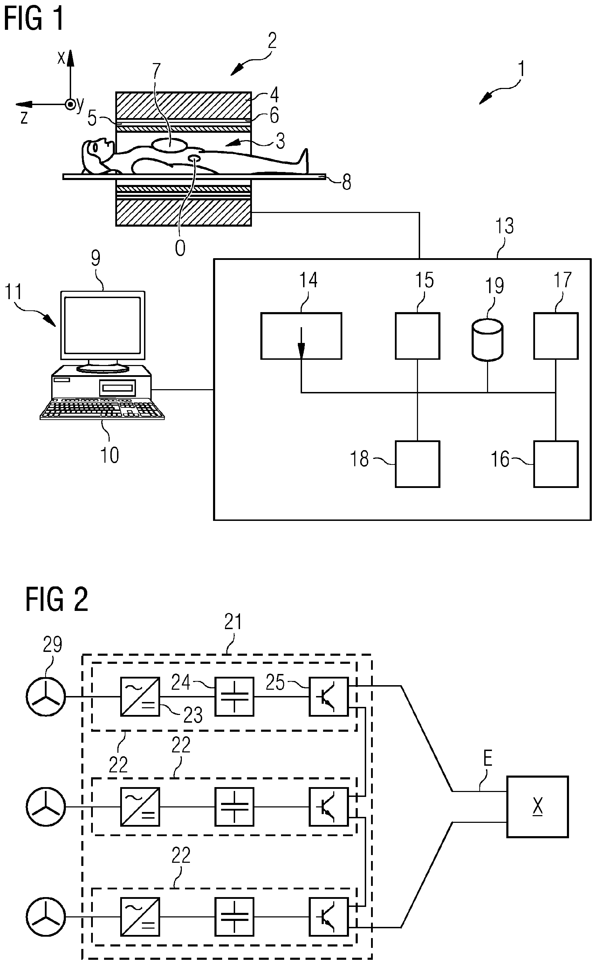

In Figur 1 ist grob schematisch ein Magnetresonanztomographie-System 1 dargestellt. Es umfasst zum einen den eigentlichen Magnetresonanzscanner 2 mit einem Untersuchungsraum 3 bzw. Patiententunnel (wird hier als Aufnahmebereich 3 angesehen), in den auf einer Liege 8 ein Patient oder Proband positioniert ist, in dessen Körper sich das eigentliche Untersuchungsobjekt O befindet.

Der Magnetresonanzscanner 2 ist in üblicher Weise mit einem Grundfeldmagnetsystem 4, einem Gradientensystem 6 sowie einem HF-Sendeantennensystem 5 und einem HF-Empfangsantennensystem 7 ausgestattet. In dem dargestellten Ausführungsbeispiel handelt es sich bei dem HF-Sendeantennensystem 5 um eine im Magnetresonanzscanner 2 fest eingebaute Ganzkörperspule, wogegen das HF-Empfangsantennensystem 7 aus am Patienten bzw. Probanden anzuordnenden Lokalspulen besteht (hier nur durch eine einzelne Lokalspule symbolisiert). Grundsätzlich können aber auch die Ganzkörperspule als HF-Empfangsantennensystem und die Lokalspulen als HF-Sendeantennensystem genutzt werden, sofern diese Spulen jeweils in unterschiedliche Betriebsweisen umschaltbar sind. Das Grundfeldmagnetsystem 4 ist hier in üblicher Weise so ausgebildet, dass es ein Grundmagnetfeld in Längsrichtung des Patienten erzeugt, d. h. entlang der in z-Richtung verlaufenden Längsachse des Magnetresonanzscanners 2. Das Gradientensystem 6 umfasst in üblicher Weise einzeln ansteuerbare Gradientenspulen X, Y, Z (s. z.B. Figur 3), um unabhängig voneinander Gradienten in x-, y- oder z-Richtung schalten zu können.

Bei dem hier dargestellten Magnetresonanztomographie-System handelt es sich um eine Ganzkörperanlage mit einem Patiententunnel, in den ein Patient komplett eingebracht werden kann. Grundsätzlich kann die Erfindung aber auch an anderen Magnetresonanztomographie-Systemen verwendet werden. Wesentlich ist nur, dass entsprechende Aufnahmen des Untersuchungsobjekts O angefertigt werden können.

Das Magnetresonanztomographie-System 1 weist weiterhin eine zentrale Steuereinrichtung 13 auf, die zur Steuerung des MR-Systems 1 verwendet wird. Diese zentrale Steuereinrichtung 13 umfasst eine Sequenzsteuereinheit 14. Mit dieser wird die Abfolge von Hochfrequenz-Pulsen (HF-Pulsen) und von Gradientenpulsen in Abhängigkeit von einer gewählten Pulssequenz oder einer Abfolge von mehreren Pulssequenzen zur Aufnahme mehrerer Schichten im Aufnahmebereich innerhalb einer Messsitzung gesteuert. Eine solche Pulssequenz kann beispielsweise innerhalb eines Mess- oder Steuerprotokolls vorgegeben und parametrisiert sein. Üblicherweise sind verschiedene Steuerprotokolle für unterschiedliche Messungen bzw. Messsitzungen in einem Speicher 19 hinterlegt und können von einem Bediener ausgewählt (und bei Bedarf gegebenenfalls geändert) und dann zur Durchführung der Messung genutzt werden.

Anhand von ausgewählten Pulssequenzen oder anhand der Positionierung des oben genannten HF-Empfangsantennensystems 7 kann der Untersuchungsbereich festgelegt werden.

Zur Ausgabe der einzelnen HF-Pulse einer Pulssequenz weist die zentrale Steuereinrichtung 13 eine Hochfrequenzsendeeinrichtung 15 auf, die die HF-Pulse erzeugt, verstärkt und über eine geeignete Schnittstelle (nicht im Detail dargestellt) in das HF-Sendeantennensystem 5 einspeist.

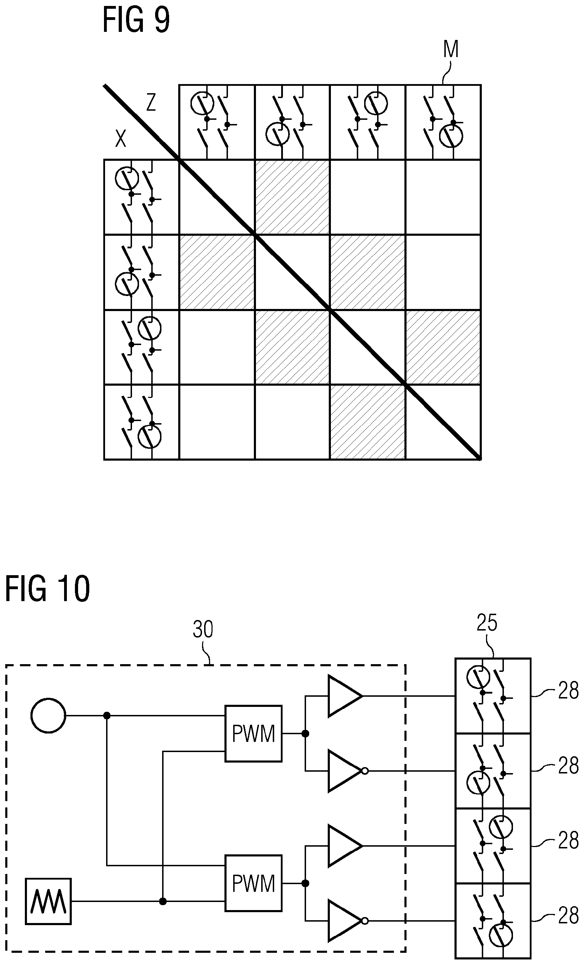

Zur Steuerung der Gradientenspulen X, Y, Z des Gradientensystems 6, um entsprechend der vorgegebenen Pulssequenz die Gradientenpulse passend zu schalten, weist die Steuereinrichtung 13 eine Gradientensystemschnittstelle 16 auf. Über diese Gradientensystemschnittstelle 16 könnten die Diffusions-Gradientenpulse und Spoiler-Gradientenpulse appliziert werden. Die Sequenzsteuereinheit 14 kommuniziert in geeigneter Weise, z.B. durch Aussendung von Sequenzsteuerdaten, mit der Hochfrequenzsendeeinrichtung 15 und der Gradientensystemschnittstelle 16 zur Ausführung der Pulssequenz. Man kann hier davon ausgehen, dass die Gradientensystemschnittstelle 16 die Steuerpulse zum Schalten der Schalter 28 der Brückeneinheiten 25 sendet also die Schalteinheit 30 nach Figur 10 aufweist.

Die Steuereinrichtung 13 weist außerdem eine (ebenfalls in geeigneter Weise mit der Sequenzsteuereinheit 14 kommunizierende) Hochfrequenzempfangseinrichtung 17 auf, um innerhalb der durch die Pulssequenz vorgegebenen Auslesefenster koordiniert mittels des HF-Empfangsantennensystems 7 Magnetresonanz-Signale zu empfangen und so die Rohdaten zu akquirieren.

Eine Rekonstruktionseinheit 18 übernimmt hier die akquirierten Rohdaten und rekonstruiert daraus Magnetresonanz-Bilddaten. Auch diese Rekonstruktion erfolgt in der Regel auf Basis von Parametern, die in dem jeweiligen Mess- oder Steuerprotokoll vorgegeben sein können. Diese Bilddaten können dann beispielsweise in einem Speicher 19 hinterlegt werden.

Wie im Detail durch ein Einstrahlen von HF-Pulsen und das Schalten von Gradientenpulsen geeignete Rohdaten akquiriert und daraus MR-Bilder oder Parameter-Karten rekonstruiert werden können, ist dem Fachmann grundsätzlich bekannt und wird daher hier nicht näher erläutert.

Die Gradientenspulen X, Y, Z des Gradientensystems 6 werden bei einer MRT-Aufnahme von Strömen durchflossen (nicht konstant, sondern eine alternierende Funktion), welche sie von einem (hier nicht eingezeichneten) Gradientenverstärker erhalten (bzw. eines Endstufensystems 20 gemäß der Erfindung). Die Brückeneinheiten 25 der Endstufen 21 werden dann von der Gradientensystemschnittstelle 16 geschaltet.

Der beispielhafte Aufbau einer Endstufe 21 mit einer am Endstufenausgang E angeschlossenen Gradientenspule X ist in Figur 2 dargestellt. Die Endstufe 21 umfasst hier drei Zylinder 22. Je nach Anwendung können auch mehr oder weniger Zylinder vorhanden sein, wobei eine ungeradzahlige Anzahl bevorzugt ist, um bestimmte Schwingungszustände zu unterdrücken.

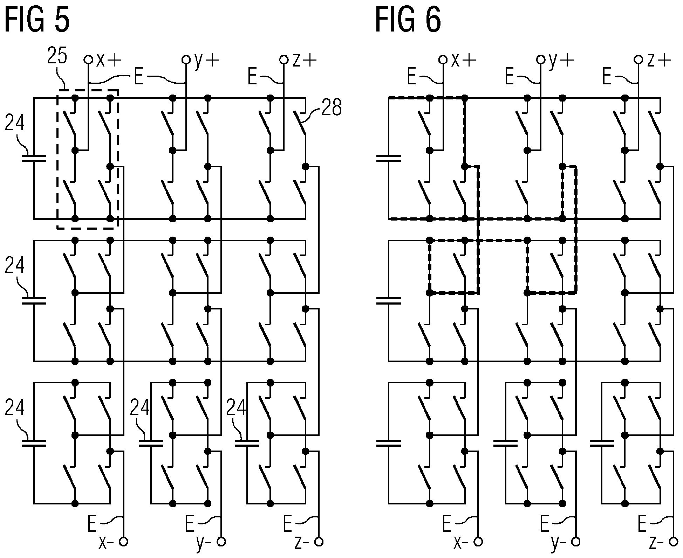

Die Zylinder umfassen in diesem Beispiel jeweils eine Stromwandlungseinheit 23 (Gleichrichter) und eine Kondensatoreinheit 24 sowie eine mit dieser Kondensatoreinheit 24 gekoppelte Brückeneinheit 25, wobei die drei Brückeneinheiten 25 untereinander in Reihe verschaltet sind, so wie es z.B. in Figur 5 gezeigt ist, auf die später noch näher eingegangen wird. Diese Verschaltung ist Stand der Technik. Mittels der Brückeneinheiten 25 können Ladungen der Kondensatoreinheiten 24 je nach den Stellungen der Schalter 28 der Brückeneinheiten 25 abgegriffen und zu Strompulsen für die Gradientenspule X verwendet werden. Es ist dabei insbesondere möglich die Spannungen der Kondensatoreinheiten 24 zu addieren.

Figur 3 zeigt drei Endstufen 21 gemäß Figur 2 für drei Gradientenspulen X, Y, Z eines Gradientensystems 6. Die drei Endstufen bilden einen Gradientenverstärker gemäß dem Stand der Technik. Links ist mit einem Pfeil die Energieversorgung angedeutet. Beispielsweise wird eine Transformatorspule von Strom durchflossen und am Magnetjoch des Transformators (mit dem linken Kasten angedeutet) greifen die neun Sekundärspulen der neun Stromwandlungseinheiten 23 an. Für diesen Gradientenverstärker werden insgesamt neun vollständige Zylinder 22 benötigt, die alle galvanisch voneinander getrennt sind.

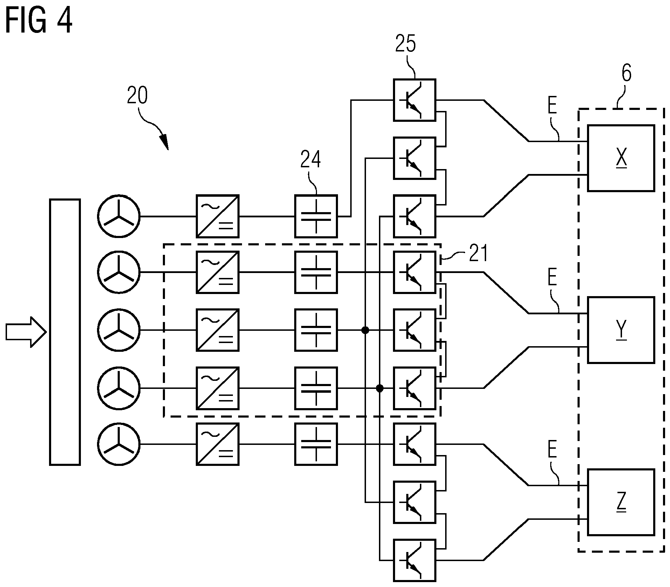

Figur 4 zeigt ein Beispiel für ein erfindungsgemäßes Endstufensystem 20 mit drei Gradientenspulen X, Y, Z eines Gradientensystems 6. Auch hier weist jede der Endstufen 21 mehrere Zylinder auf wie in Figur 2 gezeigt. Im Unterschied zu Figur 3 gibt es jedoch zwei Kondensatoreinheiten 24, die mit jeweils einer Brückeneinheit 25 jeder der drei Endstufen 21 verbunden sind. In diesem Beispiel umfasst der Gradientenverstärker also im Grunde drei Endstufen 21, wobei zwei Brückeneinheiten 25 von jeder der Endstufen 21 mit jeweils derselben Kondensatoreinheit 24 verbunden ist. Es ist dabei jeweils die erste (unterste) Brückeneinheit 25 von jeder der Endstufen 21 mit derselben ersten Kondensatoreinheit 24 verbunden, und zusätzlich jeweils eine zweite (mittlere) Brückeneinheit 25 von jeder der Endstufen 21 mit derselben zweiten Kondensatoreinheit 24 verbunden.

In diesem Beispiel wird jeder Endstufenausgang E aus drei seriell verschalteten Brückeneinheiten 25 gebildet. Es könnten aber auch fünf oder sieben (oder im Grunde jede beliebige Anzahl) sein. In dem hier dargestellten Fall können im Vergleich zu Figur 3 insgesamt vier Teile von Zylindern, nämlich die Stromwandlungseinheit sowie die Kondensatoreinheit eingespart werden. Bei fünf oder sieben Zylindern können es durchaus mehr sein.

Die im Bild zuoberst angeordnete Brückeneinheit 25 jeder der Endstufen 21 ist von den anderen Endstufen 21 galvanisch getrennt. Man könnte zwar theoretisch auch diese wie die anderen an einer Kondensatoreinheit betreiben, dies könnte jedoch in der Praxis zu einer zu großen Einschränkung der möglichen Betriebsmodi führen, Wie weiter unten noch ausführlicher gezeigt wird, können bestimmte Schaltkonfigurationen der Brückeneinheiten 25 zu unerwünschten Zuständen (Kurzschlüssen, Lastschlüssen) führen, die vermieden werden sollten. Eine galvanische Trennung sorgt für eine größere Anzahl von möglichen Schalterstellungen ohne unerwünschte Zustände. Die Galvanische Trennung betrifft bevorzugt eine Brückeneinheit 25 am Anfang oder am Ende der Serienschaltung der betreffenden Endstufe 21. Dies hat eine positive Auswirkung auf die Reduktion unerwünschter Zustände.

Figur 5 zeigt die Verschaltung der H-Brücken der Brückeneinheiten eines erfindungsgemäßen Endstufensystems. Von links nach rechts sind die Endstufenausgänge (mit x, y und z bezeichnet) für die drei Gradientenspulen X, Y, Z dargestellt. Es gibt dabei einen bestimmungsgemä-βen Spuleneingang ("+") und einen bestimmungsgemäßen Spulenausgang ("-").

Die Schalter 28 der als H-Brücken ausgestalteten Brückeneinheiten 25 sind hier alle geöffnet. die vier Eingänge der Brückeneinheiten 25 sind jeweils paarweise mit den Polen der Kondensatoreinheit 24 verbunden, die beiden Ausgänge sind so verschaltet, dass der eine Ausgang jeweils mit der vorangehenden Instanz (von unten) verschaltet ist und der andere Ausgang mit der nachfolgenden Instanz (oben). Auf diese Weise können mit einer geeigneten Schalterstellung z.B. alle drei Kondensatoreinheiten 24 eines Strangs in Reihe mit den Endstufenausgängen E verschaltet werden, aber auch nur eine oder zwei.

In diesem Beispiel sind die unteren H-Brücken galvanisch voneinander getrennt und mit jeweils einer eigenen Kondensatoreinheit 24 verbunden. In der Figur 3 würden diese Brückeneinheiten 25 den jeweils oberen entsprechen.

Figur 6 zeigt die Schaltung der Figur 5 mit einem Beispiel für eine verbotene Schaltkombination der H-Brücken der Brückeneinheiten 25. Es sind hier einige Schalter 28 geschlossen, so dass der dich gestrichelte Pfad einen Kurzschluss der oberen Kondensatoreinheit 24 darstellt. Mit anderen Schalterstellungen könnten zwei Kondensatoreinheiten 24 miteinander kurzgeschlossen werden und mit wiederum anderen Endstufenausgänge E.

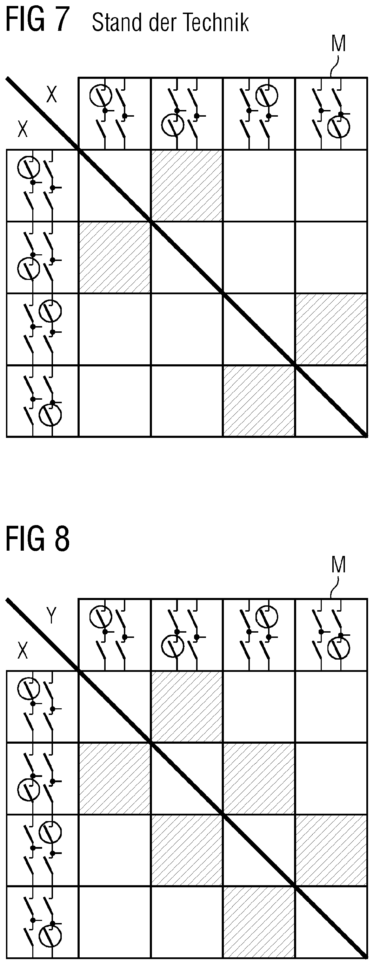

Figur 7 zeigt eine Tabelle mit verbotenen Schaltkombinationen der X-Endstufe 21. Dies sind die typischen verbotenen Schalterstellungen innerhalb eines Strangs (X-X), wie sie im Stand der Technik bekannt sind. Wie man schon in der Figur 5 erahnen kann, dürfen in einer H-Brücke die beiden direkt übereinanderliegenden Schalter 28 nicht geschlossen werden, damit die Kondensatoreinheit nicht kurzgeschlossen wird. Dies wird im Übrigen durch das Buffer/Inverter-Paar am Ausgang der Schalteinheit 30 der Figur 10 erreicht.

Wie man der Tabelle entnehmen kann, sind Schaltkombinationen direkt übereinanderliegender Schalter verboten (schraffierte Tabellenzelle).

Wie Figur 6 andeutet, können auch Schaltkombinationen von Schaltern unterschiedlicher Stränge verboten sein, da sie zu unerwünschten Zuständen führen. In den Figuren 8 und 9 sind diese angedeutet (schraffierte Zellen). Verbotene Schaltkombinationen zwischen dem Y- und Z-Strang würden entsprechend aussehen.

Figur 8 zeigt eine Tabelle mit verbotenen Schaltkombinationen zwischen X-Endstufe und Y-Endstufe. Würde man den Schalter links oben mit "1" bezeichnen, den Schalter links unten mit "2" den Schalter rechts oben mit "3" und den Schalter rechts unten mit "4", so wären die Schaltkombinationen X1+Y2, X2+Y1, X2+Y3, X3+Y2, X3+Y4 und X4+Y3 verboten. Diese Tabelle ist wie auch die Nachfolgenden lediglich ein Beispiel für drei Zylinder 21. Sind mehr Zylinder vorhanden, würde sich diese Tabelle diagonal fortsetzen.

Figur 9 zeigt eine Tabelle mit verbotenen Schaltkombinationen zwischen X-Endstufe und Z-Endstufe. Hier sind die Schaltkombinationen X1+Z2, X2+Z1, X2+Z3, X3+Z2, X3+Z4 und X4+Z3 verboten.

Bezüglich der Y- und Z- Stränge wären die Schaltkombinationen sowie Y1+Z2, Y2+Z1, Y2+Z3, Y3+Z2, Y3+Z4 und Y4+Z3 verboten.

Figur 10 zeigt eine Schalteinheit 30 für Brückeneinheiten. Diese ist im Grunde Stand der Technik und könnte in der Gradientensystemschnittstelle 16 angeordnet sein. Ein Frequenzgenerator (links unten durch ein Dreiecksmuster angedeutet versorgt Pulsweitenmodulatoren (PWM) mit einem Signal und links oben wird die gewünschte Signalform eingegeben. Die Pulsweitenmodulatoren geben dann Schaltsignale für die Schalter 28 einer Brückeneinheit 25 aus und zwar entsprechend der Tabelle nach Figur 7 jeweils durch eine Buffer und einen Inverter Wechselweise, so dass direkt übereinander liegende Schalter 28 nicht gleichzeitig schalten.

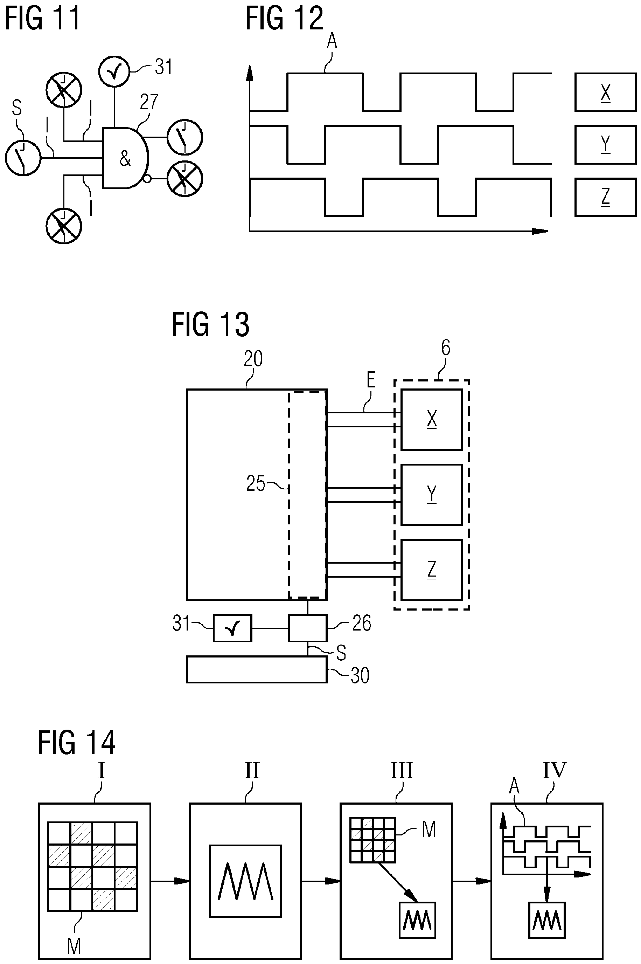

Figur 11 zeigt eine Riegeleinheit 27 zur Unterdrückung von Schaltsignalen, die zwischen jeden der Ausgänge der Schalteinheit 30 von Figur 10 und den jeweiligen Schalter 28 geschaltet werden kann. Es handelt sich dabei im Grunde um ein AND-Gatter, welches einen normalen und einen invertierten Ausgang hat (also ein AND/NAND-Gatter) Diese Gatter können in Form von Hardware oder Software vorliegen. Die Riegeleinheit hat neben dem Eingang I für das Schaltsignal noch weitere Eingänge I, um das Schaltsignal zu unterdrücken. Diese liegen bevorzugt in Form invertierter Ausgangssignale der anderen Riegeleinheiten 27 vor. Wäre beispielsweise das Eingangssignal für diese Riegeleinheit das Schaltsignal für X1, so würde das invertierte Ausgangssignal gemäß den Tabellen der Figuren 8 und 9 auf die Riegeleinheiten für Y2 und Z2 gehen, um die Schaltsignale für Y2 und Z2 zu unterdrücken, wenn X1 geschaltet ist. Die Verschaltung der Riegeleinheiten 27 kann man also direkt aus den Figuren 8 und 9 und der analogen Verriegelung der Schaltsignale für Y und Z ableiten.

Die verschalteten Riegeleinheiten 27 bilden zusammen das Verriegelungssystem 26, welches in der Figur 13 abgebildet ist.

Zudem ist an die Riegeleinheit 27 eine Aktivierungs-Steuereinheit 31 angeschlossen, die dazu ausgelegt ist, eine Brückeneinheit 25 über die die Riegeleinheiten 27 zu aktivieren oder deaktivieren. Sie könnte an einen separaten "Enable"-Eingang der Riegeleinheiten 27 angeschlossen sein oder an einen Eingang I der Riegeleinheiten 27.

In Figur 12 ist ein beispielhaftes Schema, ein "Aktivierungsmuster" A dargestellt, welches zeigt, wie die Riegeleinheiten 27 blockweise geschaltet werden könnten. Die Riegeleinheiten 27 für die Endstufenausgänge für die X-Gradientenspule X könnten blockweise nach der obersten Kurve geschaltet werden, die Riegeleinheiten 27 für die Endstufenausgänge für die Y-Gradientenspule Y blockweise nach der mittleren Kurve und die Riegeleinheiten 27 für die Endstufenausgänge für die Z-Gradientenspule Z blockweise nach der untersten Kurve, wobei jeweils ein unteres Signal eine Inaktivität bedingt und ein oberes Signal eine Aktivität. Man sieht, dass hier immer zwei Spulen aktiv sind, was möglicherweise auch Auswirkungen auf verbotene Schalterstellungen haben kann.

Figur 13 zeigt ein erfindungsgemäßes Endstufensystem 20 mit drei Gradientenspulen X, Y, Z, Schalteinheit 30 nach Figur 10, einem Verriegelungssystem 26 mit Riegeleinheiten nach Figur 11 und eine Aktivierungs-Steuereinheit 31, die nach den Kurven von Figur 12 die Riegeleinheiten 27 des Verriegelungssystems 27 blockweise aktiviert oder deaktiviert. Die Schalteinheit 30 sendet ein Schaltsignal S an die Brückeneinheiten 25, wobei dieses Schaltsignal S die Stellungen aller Schalter 28 der Brückeneinheiten 25 zu einem bestimmten Zeitpunkt umfasst. Dieses Schaltsignal S wird durch das Verriegelungssystem 26 gefiltert, indem nur zulässige Schalterstellungen durchgelassen werden. In dem Verriegelungssystem 26 werden mit der Aktivierungs-Steuereinheit 31 einzelne Riegeleinheiten 27 blockweise aktiviert bzw. gesperrt, so dass das Schaltsignal S dadurch noch weiter gefiltert wird.

Figur 14 zeigt den Ablauf des Verfahrens zur Steuerung eines Endstufensystems 20 nach Figur 13 als Blockschaltbild.

In Schritt I wird eine Tabelle M von verbotenen Schaltkombinationen für die Brückeneinheiten 25 vorgegeben.

In Schritt II wird ein Datenstrom mit einem Soll-Stromverlauf für eine Untersuchung empfangen und Soll-Schaltkombinationen ermittelt, mit denen die Brückeneinheiten 25 geschaltet werden müssen, um den Soll-Stromverlauf zu erreichen.

In Schritt III werden verbotene Schaltkombinationen der Soll-Schaltkombinationen basierend auf der vorgegebenen Tabelle M unterdrückt.

In Schritt IV (der parallel zu Schritt III erfolgen kann) werden zusätzlich noch die Riegeleinheiten blockweise nach einem Aktivierungsmuster A aktiviert und deaktiviert und dadurch ggf. weitere Soll-Schaltkombinationen unterdrückt.

Die Steuerbefehle zum Schalten der Schalter der Brückeneinheiten 25 werden dann ausgegeben.

Es wird abschließend noch einmal darauf hingewiesen, dass es sich bei der vorhergehend detailliert beschriebenen Erfindung lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schlie-βen Begriffe wie "Einheit" nicht aus, dass die betreffenden Komponenten aus mehreren zusammenwirkenden Teil-Komponenten bestehen, die ggf. auch räumlich verteilt sein können. Der Begriff "eine Anzahl" ist als "mindestens ein(e)" zu lesen. Unabhängig vom grammatikalischen Geschlecht eines bestimmten Begriffes sind Personen mit männlicher, weiblicher oder anderer Geschlechteridentität mit umfasst.

## Patentansprüche

1. Endstufensystem (20) für einen Gradientenverstärker umfassend mehrere Endstufen (21) für unterschiedliche Gradientenspulen (X, Y, Z), wobei jede der Endstufen (21) mehrere Zylinder aufweist und, wobei jeder Zylinder (22) zumindest eine Schaltung aus einer Kondensatoreinheit (24) und mindestens einer Brückeneinheit (25) umfasst, wobei mehrere Brückeneinheiten (25) seriell als Endstufenausgang (E) verschaltet sind, und wobei Brückeneinheiten (25) von zumindest zwei unterschiedlichen Endstufen (21) mit derselben Kondensatoreinheit (24) verbunden sind.

2. Endstufensystem (20) nach Anspruch 1, wobei der Gradientenverstärker mindestens drei Endstufen (21) umfasst und mindestens eine Brückeneinheit (25) von jeder der Endstufen (21) mit derselben Kondensatoreinheit (24) verbunden ist,
bevorzugt wobei jeweils eine erste Brückeneinheit (25) von jeder der Endstufen (21) mit derselben ersten Kondensatoreinheit (24) verbunden ist, und zusätzlich jeweils eine zweite Brückeneinheit (25) von jeder der Endstufen (21) mit derselben zweiten Kondensatoreinheit (24) verbunden ist.

3. Endstufensystem (20) nach Anspruch 1 oder 2, wobei jeder Endstufenausgang (E) dieselbe Anzahl von seriell verschalteten Brückeneinheiten (25) umfasst, bevorzugt mindestens drei, fünf oder sieben.

4. Endstufensystem (20) nach einem der vorangehenden Ansprüche, wobei die Serienschaltung der Brückeneinheiten (25) jedes Endstufenausgangs (E) eine funktionale Reihenfolge hat, welche von den Magnetfeldern von bestimmungsgemäß an die Endstufen (21) angeschlossenen Gradientenspulen (X, Y, Z) bestimmt wird und Brückeneinheiten (25) von zumindest zwei unterschiedlichen Endstufen (21), die mit derselben Kondensatoreinheit (24) verbunden sind, jeweils bezüglich ihrer Stellung in der Reihenfolge gleichartige Brückeneinheiten (25) sind.

5. Endstufensystem (20) nach einem der vorangehenden Ansprüche, wobei zumindest eine Brückeneinheit (25) jeder der Endstufen (21) von den anderen Endstufen (21) galvanisch getrennt ist,
bevorzugt eine Brückeneinheit (25) am Anfang oder am Ende der Serienschaltung der betreffenden Endstufe (21).

6. Endstufensystem (20) nach einem der vorangehenden Ansprüche, umfassend ein Verriegelungssystem (26), welches vorgegebene Schaltkombinationen der Brückeneinheiten (25) verhindert, insbesondere blockiert, bevorzugt wobei das Verriegelungssystem (26) dazu ausgestaltet ist, Schaltkombinationen zu unterdrücken oder nicht zu generieren, die
- zu einem Kurzschluss zwischen den Anschlüssen einer Kondensatoreinheit (24) führen,
- zu einer direkten Verbindung zwischen den Anschlüssen zweier Kondensatoreinheiten (24) führen, oder
- zu Lastschlüssen führen.

7. Endstufensystem (20) nach Anspruch 6, wobei das Verriegelungssystem (26) für jedes Schaltsignal (S) eines Schalters (28) einer Brückeneinheit (25) eine Riegeleinheit (27) umfassend eine Anordnung logischer Gatter umfasst, insbesondere AND-Gatter und/oder NAND-Gatter, wobei jede Riegeleinheit (27) einen Eingang (I) für ein Schaltsignal (S) und eine Anzahl von Eingängen für Riegelsignale umfasst und einen Ausgang für das Schaltsignal (S) und bevorzugt einen Ausgang für das invertierte Schaltsignal (S),
bevorzugt wobei die Ausgänge der Riegeleinheiten (27) des Verriegelungssystems (26) mit den Eingängen anderer Riegeleinheiten (27) des Verriegelungssystems (26) verbunden sind und Riegelsignale an diese übertragen.

8. Endstufensystem (20) nach einem der vorangehenden Ansprüche, wobei jede Brückeneinheit (25) eine H-Brücke mit mindestens vier Schaltern (28) aufweist und wobei das Endstufensystem (20) eine Schalteinheit (30) umfasst, die dazu ausgelegt ist, die Schalter (28) der Brückeneinheiten (25) nach einem jeweils vorgegebenen Schaltmuster (M) zu schalten,
bevorzugt wobei bei einem Endstufensystem (20) nach Anspruch 6 oder 7 das Verriegelungssystem (26) dazu ausgelegt ist, vorgegebene Schaltkombinationen des Schaltmusters (M) der Schalteinheit (30) zu unterdrücken.

9. Endstufensystem (20) nach einem der vorangehenden Ansprüche, umfassend eine Aktivierungs-Steuereinheit (31) dazu ausgelegt, eine Brückeneinheit (25) zu aktivieren oder deaktivieren, bevorzugt jede Brückeneinheit (25),
bevorzugt wobei die Aktivierungs-Steuereinheit (31) dazu ausgelegt ist, bei einer Endstufe (21) gemäß Anspruch 7 eine Anzahl von Brückeneinheiten (25) mittels des Verriegelungssystems (26) zu aktivieren oder deaktivieren, vorzugsweise indem sie dazu ausgelegt ist, alle mit einer Endstufe (21) verbundenen Riegeleinheiten (27) blockweise zu aktivieren oder zu deaktivieren.

10. Verfahren zur Steuerung eines Endstufensystems (20) nach einem der vorangehenden Ansprüche, umfassend die Schritte:
- Vorgeben einer Liste oder Tabelle von verbotenen Schaltkombinationen für die Brückeneinheiten (25) des Endstufensystems (20),
- Empfangen eines Datenstroms mit einem Soll-Stromverlauf für eine Untersuchung
- Ermittlung von Soll-Schaltkombinationen, mit denen die Brückeneinheiten (25) geschaltet werden müssen, um den Soll-Stromverlauf zu erreichen,
- Ausgabe von Steuerbefehlen zum Schalten der Schalter der Brückeneinheiten (25) gemäß der Soll-Schaltkombinationen, wobei verbotene Schaltkombinationen unterdrückt werden.

11. Verfahren nach Anspruch 10, wobei eine Aktivierungsmuster (A) vorgegeben ist, nach dem die Schaltsignale (S) für die Gradientenspulen (X, Y, Z) blockweise aktiviert werden, bevorzugt so dass zu jedem Zeitpunkt Schaltsignale (S) für zwei der Gradientenspulen (X, Y, Z) aktiv sind und die Schaltsignale (S) für eine weitere Anzahl von Gradientenspulen (X, Y, Z) inaktiv sind, wobei die Schalter (28) der Brückeneinheiten (25) gemäß dem Aktivierungsmuster (A) und der gewünschten Schaltkombinationen geschaltet werden.

12. Gradientensystem (6) für ein Magnetresonanztomographiesystem (1) umfassend eine Anzahl von Gradientenspulen (X, Y, Z) und ein Endstufensystem (20) nach einem der Ansprüche 1 bis 9, wobei jeweils eine Gradientenspule (X, Y, Z) mit einem Endstufenausgang (E) einer Endstufe (21) des Endstufensystems (20) verbunden ist.

13. Magnetresonanztomographiesystem (1) umfassend ein Gradientensystem (6) nach Anspruch 12.
